# EUROPÄISCHE PATENTSCHRIFT

(11) **EP 1 129 482 B1**
(45) Veröffentlichungstag und Bekanntmachung des Hinweises auf die Patenterteilung: **07.12.2005**
(21) Anmeldenummer: 99955717.6
(22) Anmeldetag: 17.09.1999
(51) Int. Cl.: H01L 21/8242, H01L 27/108

(54) **Verfahren zur Herstellung von einer DRAM-Zellenanordnung**
Method for producing a DRAM Cell System
Procédé de production d'une configuration de cellules DRAM

(30) Priorität: 30.09.1998 DE 19845058
(43) Veröffentlichungstag der Anmeldung: 05.09.2001
(73) Patentinhaber: Infineon Technologies AG, 81669 München (DE)
(72) Erfinder: WILLER, Josef, D-85521 Riemerling (DE); HOFMANN, Franz, D-80995 München (DE); SCHLÖSSER, Till, D-81825 München (DE)
(74) Vertreter: Barth, Stephan Manuel
(86) Internationale Anmeldenummer: PCT/DE1999/002937
(87) Internationale Veröffentlichungsnummer: WO 2000/019527

(56) Entgegenhaltungen:
- EP-A- 0 489 257
- EP-A- 0 713 253
- EP-A- 0 852 396
- US-A- 5 629 226
- "DENSEST DRAM CELL" IBM TECHNICAL DISCLOSURE BULLETIN,US,IBM CORP. NEW YORK, Bd. 32, Nr. 9A, 1. Februar 1990 (1990-02-01), Seiten 380-382, XP000083113 ISSN: 0018-8689
- PATENT ABSTRACTS OF JAPAN vol. 14, no. 9 (E-870), 10. Januar 1990 (1990-01-10) & JP 01 253956 A (NIPPON TELEGR & TELEPH CORP), 11. Oktober 1989 (1989-10-11)

## Beschreibung

Die Erfindung betrifft ein Verfahren zur Herstellung einer DRAM-Zellenanordnung gemäß dem Oberbegriff des Anspruchs 1.

Ein solches Herstellungsverfahren ist aus "DENSEST DRAM CELL" IBM TECHNICAL DISCLOSURE BULLETIN, US, IBM Corp., New York, Bd. 32, Nr. 9a, 1. Febr. 1990, Seiten 380-382, bekannt.

Die DE 195 19 160 C1 offenbart eine DRAM-Zellenanordnung und ein entsprechendes Herstellungsverfahren, wobei eine streifenförmige Fotolackmaske für die Ätzvorgänge zur Herstellung der Trennstrukturen und Gräben verwendet wird.

Patent Abstracts of Japan, Vol. 14, Nr. 9 (E870, 10. Januar 1990), und JP-A-01-253956 offenbart eine Halbleiterspeichervorrichtung und ein entsprechendes Herstellungsverfahren, wobei MIS-Transistoren in Gräben mit einem Kapazitätselement verbunden sind.

Die US 5 629 226 offenbart ein Herstellungsverfahren für ein DRAM, welches in einem Graben angeordnet ist, dessen Öffnung schmäler als ein unterer Teil des Grabens ist.

Es wird allgemein angestrebt, eine DRAM-Zellenanordnung mit immer höherer Packungsdichte zu erzeugen.

In der EP 0 852 396 ist eine DRAM-Zellenanordnung beschrieben, bei der zur Erhöhung der Packungsdichte ein Transistor einer Speicherzelle über einem Speicherkondensator der Speicherzelle angeordnet ist. Aktive Gebiete der Speicherzellen werden jeweils von einer isolierenden Struktur umgeben, die in einem Substrat angeordnet ist. Im Substrat wird für jede Speicherzelle eine Vertiefung erzeugt, in deren unterem Bereich ein Speicherknoten des Speicherkondensators und in deren oberem Bereich eine Gateelektrode des Transistors angeordnet sind. Ein oberes Source-/Drain-Gebiet, ein Kanalgebiet und ein unteres Source-/Drain-Gebiet des Transistors sind im Substrat übereinander angeordnet. Das untere Source-/Drain-Gebiet ist bei einer ersten Flanke der Vertiefung mit dem Speicherknoten verbunden. Die isolierende Struktur grenzt an eine zweite der ersten Flanke gegenüberliegenden Flanke der Vertiefung an, so daß der Speicherknoten dort nicht an das Substrat angrenzt. Eine Kondensatorelektrode des Speicherkondensators wird durch Ausdiffusion von Dotierstoff in das Substrat gebildet. Ein unterer Bereich der Vertiefung wird durch einen isotropen Ätzprozeß ausgeweitet, wobei Flächen des oberen Bereichs dabei geschützt sind. Dadurch weist ein horizontaler Querschnitt des unteren Bereichs eine größere Fläche auf als ein horizontaler Querschnitt des oberen Bereichs. Durch die Verbreiterung des unteren Bereichs der Vertiefung werden die Oberfläche eines Kondensatordielektrikums und somit die Kapazität des Speicherkondensators vergrößert. Eine Bitleitung grenzt an das obere Source-/Drain-Gebiet an und verläuft oberhalb des Substrats. Die Vertiefung wird erzeugt, indem mit Hilfe einer streifenförmigen Maske, deren Streifen senkrecht zu den Bitleitungen verlaufen, das Substrat selektiv zu den Bitleitungen geätzt wird. Eine Wortleitung wird zusammen mit einer Gateelektrode erzeugt, indem Material in den oberen Bereich der Vertiefung abgeschieden und strukturiert wird. Die Gateelektrode ist durch ein Gatedielektrikum und durch die isolierende Struktur vom Substrat und von den Bitleitungen isoliert.

In der deutschen Patentschrift 195 19 160 ist eine DRAM-Zellenanordnung beschrieben, bei der ein Speicherkondensator oberhalb eines vertikalen Transistors angeordnet ist. Mit Hilfe einer durch Spacer verbreiterten Maske werden erste Gräben erzeugt, die eine Schichtenfolge durchtrennen und mit einer ersten Isolationsstruktur aufgefüllt werden. Anschließend werden zweite Gräben erzeugt, die quer zu den ersten Gräben verlaufen und flacher und breiter als die ersten Gräben sind. Die zweiten Gräben werden mit einer zweiten Isolationsstruktur gefüllt. Die Isolationsstrukturen werden rückgeätzt, so daß sich eine gitterförmige Vertiefung ergibt. Nach Erzeugung des Gatedielektrikums wird zur Erzeugung von Wortleitungen leitendes Material abgeschieden und rückgeätzt, so daß aufgrund der unterschiedlichen Breiten der Gräben die Wortleitungen selbstjustiert so erzeugt werden, daß sie parallel zu den zweiten Gräben verlaufen. Teile der Schichtenfolge, die durch die Wortleitungen umgeben werden, wirken als die Transistoren. Über den Wortleitungen und der Schichtenfolge wird ein Kondensatordielektrikum und darüber eine Kondensatorplatte der Speicherkondensatoren erzeugt. Obere Teile der Schichtenfolge wirken als obere Source-/Drain-Gebiete der Transistoren und gleichzeitig als Kondensatorelektroden der Speicherkondensatoren. Die Speicherzelle ist mit einer Fläche von 4F² herstellbar, wobei F die minimale, in der verwendeten Technologie herstellbare Strukturgröße ist. Untere Teile der Schichtenfolge wirken als Bitleitungen, die durch die ersten Isolationsstrukturen voneinander getrennt sind und parallel zu den ersten Gräben verlaufen. Weder die Wortleitungen noch die Bitleitungen weisen eine hohe elektrische Leitfähigkeit auf. Insbesondere ist aus dieser Druckschrift bekannt, Hilfsspacer bei der Herstellung der Gräben für die Grabenkondensatoren zu verwenden.

Der Erfindung liegt das Problem zugrunde, ein Herstellungsverfahren für eine DRAM-Zellenanordnung anzugeben, deren Wortleitungen und Bitleitungen eine hohe elektrische Leitfähigkeit aufweisen können und die zugleich mit einer hohen Packungsdichte herstellbar ist.

Das Problem wird durch ein Verfahren zur Herstellung einer DRAM-Zellenanordnung nach Anspruch 1 gelöst, bei dem zunächst in einem Substrat im wesentlichen parallel zueinander verlaufende erste Gräben erzeugt werden. Die ersten Gräben werden mit Trennstrukturen gefüllt. Durch Atzen mit Hilfe einer streifenförmigen Photolackmaske, deren Streifen quer zu den ersten Gräben verlaufen, wird das Substrat selektiv zu den Trennstrukturen geätzt, so daß Vertiefungen erzeugt werden. Flächen von unteren Bereichen der Vertiefungen werden mit einem Kondensatordielektrikum versehen. In den unteren Bereichen der Vertiefungen wird jeweils ein Speicherknoten eines Speicherkondensators erzeugt. Obere Source/Drain-Gebiete der Transistoren werden so erzeugt, daß sie jeweils zwischen zwei zueinander benachbarten der Vertiefungen und zwischen zwei zueinander benachbarten der Trennstrukturen angeordnet sind und an eine Hauptfläche des Substrats angrenzen. Mindestens erste Flanken der Vertiefungen in oberen Bereichen der Vertiefungen werden mit einem Gatedielektrikum versehen. Untere Source-/Drain-Gebiete der Transistoren im Substrat werden so gebildet, daß sie mit den Speicherknoten elektrisch verbunden sind, so daß jeweils einer der Transistoren und einer der speicherkondensatoren in Reihe geschaltet sind und eine Speicherzelle bilden. Durch Abscheiden und Strukturieren von leitendem Material werden Wortleitungen, die quer zu den Trennstrukturen und oberhalb der Hauptfläche verlaufen, und daran angrenzend Gateelektroden von vertikalen Transistoren erzeugt, die jeweils in einer der Vertiefungen angeordnet und von den Speicherknoten elektrisch isoliert sind. Über den Wortleitungen wird eine isolierende Schicht erzeugt. Durch Abscheiden und Rückätzen von Material werden isolierende Spacer an Flanken der Wortleitungen erzeugt. Mit Hilfe einer streifenförmigen Photolackmaske, deren Streifen in wesentlichen parallel zu den Trennstrukturen verlaufen, wird selektiv zur isolierenden Schicht und den Spacern geätzt, bis die oberen Source/Drain-Gebiete freigelegt werden. Bitleitungen Werden erzeugt, die die oberen Source/Brain-Gebiete kontaktieren.

Ausgestaltungen der Erfindung gehen aus den Ansprüchen hervor.

Der Erfindung liegt die Erkenntnis zugrunde, daß es vorteilhaft ist, Materialien mit hohen elektrischen Leitfähigkeiten, wie zum Beispiel Metalle, oberhalb des Substrats abzuscheiden, da sie zum einen Kanten, die zum Beispiel durch Vertiefungen im Substrat gebildet werden, schlecht, das heißt nicht gleichmäßig bedecken und zum anderen in einem Abstand vom Substrat angeordnet werden sollten, um eine Verunreinigung des Substrats zu vermeiden. Auch mechanische Verspannungen oder durch die Abscheidung bedingte Schädigungen einer Oberfläche des Substrats werden dadurch vermieden.

Darüber hinaus liegt der Erfindung die Erkenntnis zugrunde, daß die Materialien mit hohen elektrischen Leitfähigkeiten vorzugsweise zum Schluß von einem Herstellungsverfahren aufgebracht werden, damit sich keine Prozeßschritte mit hohen Temperaturen anschließen, die zu einer Degradation darunterliegender Schichten durch Interdiffusion in Grenzflächen zwischen den Schichten und den Materialien führen.

Da sowohl die Bitleitungen als auch die Wortleitungen oberhalb des Substrats verlaufen, können sie Materialien mit hohen elektrischen Leitfähigkeiten enthalten. Darüber hinaus können die Bitleitungen und/oder die Wortleitungen gleichzeitig mit Gateelektroden von Transistoren einer Peripherie der DRAM-Zellenanordnung erzeugt werden, indem eine Schicht oder eine Schichtenfolge aus leitenden Materialien mit Hilfe einer Maske durch Ätzen strukturiert wird. Die Bitleitungen und die Wortleitungen haben einen sogenannten planaren Aufbau. Im Gegensatz dazu können Wortleitungen und Bitleitungen der DRAM-Zellenanordnung aus der oben zitierten Patentschrift 195 19 160, die in Vertiefungen angeordnet oder Teile des Substrats sind, nur eine eher niedrige elektrische Leitfähigkeit aufweisen, was zur Folge hat, daß schon nach wenigen Speicherzellen elektrische Verbindungen zu höheren, niederohmigeren Verdrahtungsebenen hergestellt werden müssen, so daß die Pakkungsdichte der DRAM-Zellenanordnung erniedrigt und die Komplexität durch die Zahl der Verdrahtungsebenen erhöht wird.

Sowohl die Wortleitungen als auch die Bitleitungen werden nach Erzeugung der Speicherzellen erzeugt, so daß die Verwendung von Metallen ohne Gefahr der Verunreinigung des Substrats oder einer sonstigen Wechselwirkung mit dem Substrat möglich ist.

Die Bitleitungen können durch Abscheiden und Strukturieren von einem oder mehreren leitenden Materialien mit Hilfe einer streifenförmigen Photolackmaske, deren Streifen parallel zu den Trennstrukturen verlaufen und die oberen Source/Drain-Gebiete mindestens teilweise nicht bedecken, erzeugt werden. Alternativ bedeckt eine Isolation die Wortleitungen, so daß beim Freilegen der oberen Source/Drain-Gebiete zweite Gräben in der Isolation erzeugt werden. Die Bitleitungen können selbstjustiert, d.h. ohne Verwendung einer zu justierenden Maske, in den zweiten Gräben erzeugt werden, indem die leitenden Materialien abgeschieden und rückgeätzt und/oder chemisch-mechanisch poliert werden, bis die Isolation freigelegt wird.

Da die Transistoren als vertikale Transistoren über den Speicherkondensatoren angeordnet sind, kann die DRAM-Zellenanordnung eine hohe Packungsdichte aufweisen. Der Platzbedarf pro Speicherzelle kann 4F² betragen. Dazu werden die ersten Gräben mit Hilfe einer Photolackmaske erzeugt, deren Streifen Breiten und Abstände voneinander aufweisen, die F betragen. Die Streifen der Photolackmaske für die Erzeugung der Vertiefungen sind ebenfalls ca. F breit und weisen Abstände voneinander auf, die F betragen. Es liegt im Rahmen der Erfindung, wenn die genannten Breiten und Abstände mehr als F betragen.

Die Trennstrukturen ermöglichen eine selbstjustierte Erzeugung der oberen Source-/Drain-Gebiete zwischen in Richtung des Verlaufs der Bitleitungen zueinander benachbarten Vertiefungen. Das obere Source-/Drain-Gebiet kann durch Strukturierung einer an die Hauptfläche angrenzenden dotierten Schicht des Substrats erzeugt werden. Die Strukturierung erfolgt durch die Erzeugung der Trennstrukturen und der Vertiefungen. Alternativ kann das obere Source-/Drain-Gebiet erzeugt werden, indem nach Erzeugung der Vertiefungen und der Trennstrukturen eine Implantation durchgeführt wird.

Es liegt im Rahmen der Erfindung, wenn nach Erzeugung der Vertiefungen das Kondensatordielektrikum aufgebracht wird und anschließend die Vertiefungen bis zu einer mittleren Höhe mit leitendem Material gefüllt werden. Dazu kann leitendes Material, wie zum Beispiel dotiertes Polysilizium, abgeschieden, planarisiert und bis zur mittleren Höhe rückgeätzt werden. Anschließend werden freiliegende Teile des Kondensatordielektrikums entfernt, so daß das Kondensatordielektrikum Flächen der Vertiefungen bis zur mittleren Höhe bedeckt. Anschließend werden die Vertiefungen durch leitendes Material bis zu einer oberen Höhe, die über der mittleren Höhe liegt, weiter aufgefüllt. Das leitende Material bildet die Speicherknoten, die zwischen der mittleren Höhe und der oberen Höhe an das Substrat angrenzen. Die unteren Source-/Drain-Gebiete werden so erzeugt, daß sie zwischen der mittleren Höhe und der oberen Höhe an die Speicherknoten angrenzen.

Die unteren Source-/Drain-Gebiete können aus einer im Substrat vergrabenen dotierten Schicht erzeugt werden. Die Strukturierung erfolgt durch die Erzeugung der Trennstrukturen und der Vertiefungen. Alternativ können die unteren Source-/Drain-Gebiete erzeugt werden, indem Dotierstoff durch einen Temperschritt aus den Speicherknoten in das Substrat diffundiert. Diese Alternative ist vorteilhaft, weil Kanalgebiete der Transistoren, die zwischen den Trennstrukturen und den Vertiefungen und zwischen den oberen Source-/Drain-Gebieten und den unteren Source-/Drain-Gebieten angeordnet sind, elektrisch miteinander verbunden sein können, so daß Floating-Body-Effekte vermieden werden.

Es ist vorteilhaft, wenn die unteren Source-/Drain-Gebiete der Transistoren jeweils nur an die erste Flanke der jeweils zugehörigen Vertiefung und insbesondere nicht an eine zweite, der ersten Flanke gegenüberliegenden Flanke der Vertiefung angrenzen. Entsprechend weist das Kondensatordielektrikum eine einzige Aussparung zwischen der mittleren Höhe und der oberen Höhe auf, die sich an der ersten Flanke der Vertiefung befindet und bei der der Speicherknoten an das untere Source-/Drain-Gebiet angrenzt. Diese Ausgestaltung ermöglicht eine Erhöhung der Packungsdichte der DRAM-Zellenanordnung, da ein Abstand zwischen der zweiten Flanke und der ersten Flanke von zueinander benachbarten Vertiefungen verkleinert werden kann, ohne daß Leckströme zwischen den zugehörigen Speicherknoten entstehen.

Zur Erzeugung einer solchen DRAM-Zellenanordnung wird nach dem Füllen der Vertiefungen bis zur mittleren Höhe eine Photolackmaske aufgebracht, die die zweiten Flanken der Vertiefungen bedeckt. Selektiv zur Photolackmaske werden die freiliegenden Teile des Kondensatordielektrikums entfernt, so daß das Kondensatordielektrikum an den zweiten Flanken der Vertiefungen erhalten bleibt. Nach Entfernen der Photolackmaske werden die Vertiefungen, wie bereits beschrieben, bis zur oberen Höhe mit leitendem Material weiter aufgefüllt, so daß die Speicherknoten nur bei den ersten Flanken der Vertiefungen zwischen der mittleren Höhe und der oberen Höhe an das Substrat angrenzen.

Es ist vorteilhaft, wenn das untere Source-/Drain-Gebiet, das an die erste Flanke der zugehörigen Vertiefung angrenzt, nicht an die zweite Flanke einer zur Vertiefung benachbarten Vertiefung angrenzt. Dadurch wird eine Ansteuerung des zugehörigen Transistors durch die Gateelektrode der benachbarten Vertiefung vermieden.

Das Kondensatordielektrikum kann auch an der zweiten Flanke der Vertiefung eine Aussparung aufweisen. Dazu wird auf die Photolackmaske, die die zweiten Flanken der Vertiefungen bedeckt, verzichtet. Das untere Source/Drain-Gebiet umfaßt zwei Teile. Ein erster Teil des unteren Source/Drain-Gebiets grenzt an die erste Flanke und ein zweiter Teil des unteren Source/Drain-Gebiets grenzt an die zweite Flanke der Vertiefung an. Wenn die Trennstrukturen höher als die mittlere Höhe liegen, weist das Kondensatordielektrikum auch an den übrigen Flanken der Vertiefungen Aussparungen auf. Das untere Source/Drain-Gebiet ist entsprechend ausgestaltet.

Quer zu den Trennstrukturen zueinander benachbarte untere Source-/Drain-Gebiete sind vorzugsweise durch die Trennstrukturen voneinander getrennt. Im diesem Fall ist das untere Source-/Drain-Gebiet höher als eine Unterkante der Trennstrukturen, z. B. im oberen Bereich der Vertiefung angeordnet. Folglich ist auch ein Teil des Speicherknotens im oberen Bereich angeordnet, und die mittlere Höhe liegt im oberen Bereich. Die ersten Flanken der Vertiefungen verlaufen quer zu dem Verlauf der Trennstrukturen.

Um zu verhindern, daß eine Gateelektrode einer Vertiefung einen Transistor der benachbarten Vertiefung ansteuert, ist es vorteilhaft, wenn isolierende Strukturen, die dicker als das Gatedielektrikum sind, an den zweiten Flanken der Vertiefungen angeordnet sind. Zur Erhöhung der Packungsdichte ist es dabei vorteilhaft, wenn die isolierenden Strukturen in den oberen Bereichen der Vertiefungen statt im Substrat angeordnet sind. Zur Erzeugung der isolierenden Strukturen werden die Wortleitungen versetzt zu den Vertiefungen so erzeugt, daß die Gateelektroden an mit dem Gatedielektrikum versehene Teile der ersten Flanken aber nicht an die zweiten Flanken der Vertiefungen angrenzen. Beim Erzeugen der Wortleitungen wird eine streifenförmige Photolackmaske verwendet, deren Streifen die ersten Flanken der Vertiefungen aber nicht die zweiten Flanken bedecken. Anschließend wird isolierendes Material abgeschieden und rückgeätzt, so daß angrenzend an die zweiten Flanken die isolierenden Strukturen erzeugt werden.

Eine Kondensatorelektrode des Kondensators ist im Substrat angeordnet und grenzt an das Kondensatordielektrikum an. Die Kondensatorelektrode kann als für alle Kondensatoren gemeinsame dotierte Schicht des Substrats ausgestaltet sein. Die dotierte Schicht kann z.B. durch Epitaxie oder Implantation vor Erzeugung der Speicherzellen erzeugt werden. Alternativ wird in den Vertiefungen eine Dotierstoffquelle eingebracht, aus der in einem Temperschritt Dotierstoff in das Substrat diffundiert und dort die dotierte Schicht bildet.

Die Dotierstoffquelle ist z.B. Arsenglas. Nach Erzeugung der Vertiefungen wird das Arsenglas abgeschieden, so daß Flächen der Vertiefungen bedeckt sind. Die unteren Bereiche der mit dem Arsenglas versehenen Vertiefungen werden mit z.B. Photolack gefüllt. Anschließend wird freiliegendes Arsenglas entfernt. Es ist vorteilhaft, nach Entfernung des Photolacks ein Schutzoxid aufzuwachsen. Das Schutzoxid verhindert, daß bei dem folgenden Temperschritt, bei dem Arsen aus dem Arsenglas in das Substrat diffundiert, Arsen verdampft. Die Kondensatorelektrode wird als ein mit Arsen dotierter Teil des Substrats erzeugt, die Teile der unteren Bereiche der Vertiefungen umgibt.

Es ist vorteilhaft, wenn die erste Flanke im oberen Bereich der Vertiefung eben und im unteren Bereich der Vertiefung gekrümmt ist. Das Wachstum des durch thermische Oxidation erzeugten Gatedielektrikums hängt von der Ausrichtung der betreffenden Teile der ersten Flanke relativ zur Kristallstruktur des Substrats ab. Sind diese Teile der ersten Flanke eben, wird ein homogenes Wachstum des Gatedielektrikums ermöglicht, da eine ebene Fläche im Gegensatz zu einer gekrümmten Fläche eine definierte Ausrichtung relativ zur Kristallstruktur aufweist. Steuerkennlinien des Transistors, bei dem das Gatedielektrikum eine homogene Dicke aufweist, weisen eine besonders hohe Unterschwellensteilheit auf. Wird ein Teil des Kondensatordielektrikums durch thermische Oxidation auf einer Fläche, die eine Kante aufweist, aufgewachsen, fällt das Oxid an der Kante besonders dünn aus. Es kann deshalb zu Leckströmen im Bereich der Kante kommen. Deshalb ist es vorteilhaft, wenn das Kondensatordielektrikum auf einer Fläche erzeugt wird, die keine Kanten aufweist. Auch wenn das Kondensatordielektrikum durch Abscheiden von Material erzeugt wird, wirken sich Kanten in der Fläche nachteilig aus, da es an den Kanten zu Feldverzerrungen kommt, die die Durchbruchsspannung des Kondensators erniedrigen können.

Es liegt im Rahmen der Erfindung, wenn der obere Bereich der Vertiefung einen im wesentlichen rechteckigen Querschnitt aufweist, der größer ist als ein Querschnitt des unteren Bereichs, der im wesentlichen kreisförmig oder ellipsenförmig ist. Dazu werden nach Erzeugung der oberen Bereiche der Vertiefungen durch Abscheiden und anisotropes Rückätzen von Material Hilfsspacer in den Vertiefungen erzeugt. Durch einen isotropen Ätzprozeß werden die Hilfsspacer abgerundet, so daß freiliegende Teile von Böden der Vertiefungen einen Umfang ohne Ecken aufweisen. Durch anisotropes Ätzen selektiv zu den Hilfsspacern werden anschließend die unteren Bereiche der Vertiefungen erzeugt.

Zur Vergrößerung der Kapazität des Speicherkondensators ist es vorteilhaft, wenn anschließend durch isotropes Ätzen des Substrats der untere Bereich der Vertiefung erweitert wird, so daß sein Querschnitt vergrößert wird. Dadurch vergrößert sich die Fläche des unteren Bereichs, auf dem das Kondensatordielektrikum angeordnet ist, so daß die Kapazität des Speicherkondensators vergrößert wird.

Es ist vorteilhaft, wenn das Kondensatordielektrikum einen ersten Teil aufweist, der Flächen der unteren Bereiche der Vertiefungen bis zu einer unteren Höhe, die unter der mittleren Höhe liegt, bedeckt, und einen zweiten Teil, der dicker als der erste Teil ist und Flächen der Vertiefungen zwischen der unteren Höhe und der mittleren Höhe bedeckt, aufweist. Durch das untere Source-/Drain-Gebiet, das Substrat und die Kondensatorelektrode wird abhängig von den gewählten Leitfähigkeitstypen ein pnp- oder ein npn-Übergang gebildet, der, angesteuert durch den Speicherknoten, Leckströme verursachen kann. Ist das Kondensatordielektrikum also zwischen der Kondensatorelektrode und dem zweiten Source-/Drain-Gebiet besonders dick, steuert der Speicherknoten den Übergang nicht mehr an und Leckströme werden vermieden.

Zur Erzeugung eines solchen Kondensatordielektrikums wird nach Erzeugung der Vertiefung der erste Teil des Kondensatordielektrikums ganzflächig aufgebracht. Anschließend werden die Vertiefungen durch leitendes Material bis zur unteren Höhe gefüllt und freiliegende Teile des ersten Teils des Kondensatordielektrikums entfernt. Anschließend wird der zweite Teil des Kondensatordielektrikums ganzflächig aufgebracht und durch Rückätzen an horizontalen Flächen entfernt. Die Vertiefungen werden anschließend bis zur mittleren Höhe, wie bereits beschrieben, mit leitendem Material gefüllt.

Im folgenden wird ein Verfahren beschrieben, bei dem verhindert wird, daß aufgrund der endlichen Selektivität von Ätzprozessen eine obere Fläche der Trennstrukturen bei der Erzeugung der Vertiefungen unter die Hauptfläche sinkt. Vor Erzeugung der Trennstrukturen werden an der Hauptfläche eine untere Schicht aus einem ersten Material und darüber eine obere Schicht aus einem zweiten Material aufgebracht. Anschließend werden die Trennstrukturen erzeugt, wobei zur Füllung der ersten Gräben das erste Material verwendet wird. Eine obere Fläche der Trennstrukturen liegt über der Hauptfläche aber unter einer oberen Fläche der unteren Schicht. Durch Abscheiden und Planarisieren vom zweiten Material, bis die untere Schicht freigelegt wird, werden über den Trennstrukturen Hilfsstrukturen aus dem zweiten Material erzeugt. Anschließend werden die Vertiefungen mit Hilfe der streifenförmigen Maske erzeugt, indem zunächst das erste Material selektiv zum zweiten Material geätzt wird, so daß die obere Fläche der Trennstrukturen unverändert oberhalb der Hauptfläche liegt, da die Hilfsstrukturen die Trennstrukturen schützen. Die Vertiefungen können anschließend erzeugt werden, indem freiliegende Teile des Substrats geätzt werden, wobei die Trennstrukturen und die untere Schicht als Maske dienen. Dabei werden aufgrund der endlichen Selektivität des Ätzprozesses die Trennstrukturen und die untere Schicht abgetragen, deren obere Flächen aufgrund der ausreichenden Dicke der unteren Schicht nicht unter die Hauptfläche sinken.

Das Substrat kann Silizium und/oder Germanium enthalten und ist vorzugsweise monokristallin, damit das Gatedielektrikum durch thermische Oxidation erzeugt werden kann.

Die Bitleitungen und die Wortleitungen können mehrschichtig aufgebaut sein. Zum Beispiel kann jeweils eine untere Schicht aus dotiertem Polysilizium und darüber eine Schicht aus Material mit besserer elektrischer Leitfähigkeit, zum Beispiel Silizid oder Metall, vorgesehen sein.

Im folgenden wird ein Ausführungsbeispiel der Erfindung anhand der Figuren näher erläutert.
- Figur 1a: zeigt einen Querschnitt durch ein Substrat, nachdem eine erste Schicht, eine zweite Schicht, eine dritte Schicht, eine vierte Schicht und Trennstrukturen, erzeugt wurden.
- Figur 1b: zeigt den Querschnitt aus Figur 1a, nachdem die vierte Schicht entfernt wurde und Hilfsstrukturen erzeugt wurden.
- Figur 2a: zeigt eine Aufsicht auf das Substrat aus Figur 1b, nachdem obere Bereiche von Vertiefungen und die Hilfsspacer erzeugt wurden. Ferner ist die Lage einer Fotolackmaske dargestellt.
- Figur 2b: zeigt einen zum Querschnitt aus Figur la senkrechten Querschnitt durch das Substrat nach den Prozeßschritten aus Figur 2a.
- Figur 3: zeigt die Aufsicht aus Figur 2a, nachdem die Hilfsspacer abgerundet wurden.
- Figur 4: zeigt den Querschnitt aus Figur 2b, nachdem ein unterer Bereich der Vertiefung, ein Kondensatordielektrikum, ein Speicherknoten und eine Photolackmaske erzeugt wurden.
- Figur 5: zeigt den Querschnitt aus Figur 4, nachdem ein Gatedielektrikum, obere Source/Drain-Gebiete, untere Source/Drain-Gebiete, eine fünfte Schicht, eine sechste Schicht und eine siebte Schicht erzeugt wurden.
- Figur 6a: zeigt den Querschnitt aus Figur 5, nachdem die fünften Schicht und die sechsten Schicht zu Wortleitungen strukturiert wurden, und Spacer, eine Isolation (in Figur 6b dargestellt), eine achte Schicht und eine neunte Schicht, die Bitleitungen bilden, und eine zehnte Schicht erzeugt wurden.
- Figur 6b: zeigt einen zum Querschnitt aus Figur 6a parallelen Querschnitt durch das Substrat nach den Prozeßschritten aus Figur 6a.

Die Figuren sind nicht maßstabsgerecht.

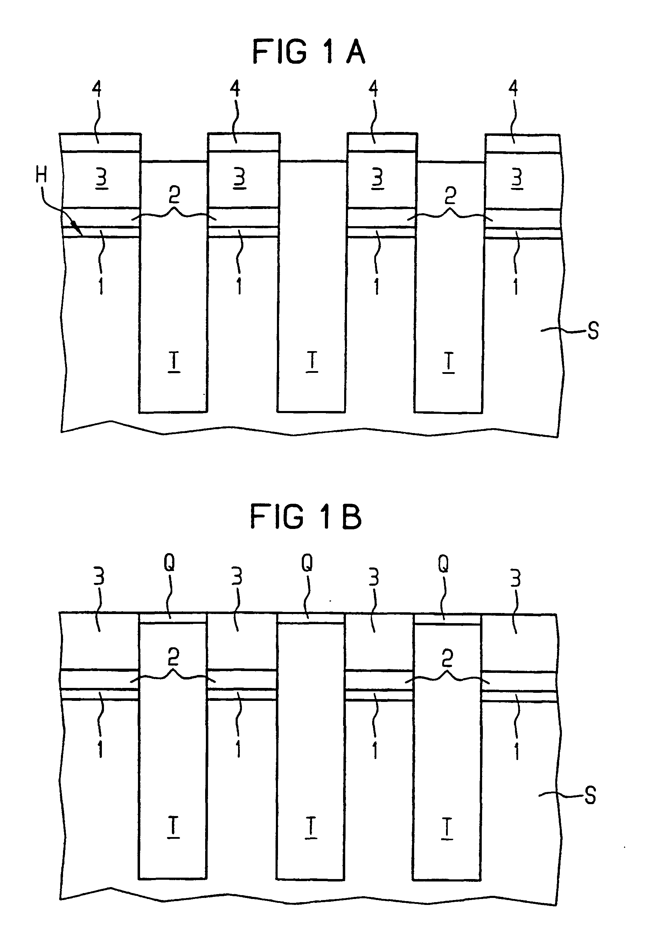

In einem Ausführungsbeispiel ist als Ausgangsmaterial ein p-dotiertes Substrat S aus Silizium vorgesehen, das in einer an einer Hauptfläche H des Substrats S angrenzenden Schicht mit einer Dotierstoffkonzentration von ca. 10¹⁸ cm⁻³ p-dotiert ist. Auf der Hauptfläche H wird eine ca. 20 nm dicke erste Schicht 1 aus SiO₂, darüber eine ca. 100 nm dicke zweite Schicht 2 aus Siliziumnitrid, darüber eine ca. 800 nm dicke dritte Schicht 3 aus SiO₂ und darüber eine ca. 100 nm dicke vierte Schicht 4 aus Siliziumnitrid abgeschieden (siehe Figur 1a).

Mit Hilfe einer streifenförmigen ersten Photolackmaske (nicht dargestellt) werden die vierte Schicht 4, die dritte Schicht 3, die zweite Schicht 2, die erste Schicht 1 und das Substrat S anisotrop geätzt, so daß im Substrat S ca. 300 nm tiefe erste Gräben erzeugt werden, die eine Breite von ca. 100 nm und Abstände von ca. 100 nm voneinander aufweisen. Als Ätzmittel sind zum Beispiel CF₄, CHF₃, C₂F₆ und HBr geeignet, die entsprechend dem zu ätzenden Material kombiniert werden.

In den ersten Gräben werden Trennstrukturen T erzeugt, indem SiO₂ in einer Dicke von ca. 200 nm konform abgeschieden und durch chemisch-mechanisches Polieren planarisiert wird, bis eine obere Fläche der vierten Schicht 4 freigelegt wird. Anschließend wird SiO₂ selektiv zum Siliziumnitrid rückgeätzt, so daß eine obere Fläche der Trennstrukturen T unterhalb einer oberen Fläche der dritten Schicht 3 liegt (siehe Figur 1a).

Anschließend wird Siliziumnitrid abgeschieden und durch chemisch-mechanisches Polieren planarisiert, bis die obere Fläche der dritten Schicht 3 freigelegt wird. Auf diese Weise sind über den Trennstrukturen T Hilfsstrukturen Q aus Siliziumnitrid angeordnet (siehe Figur 1b).

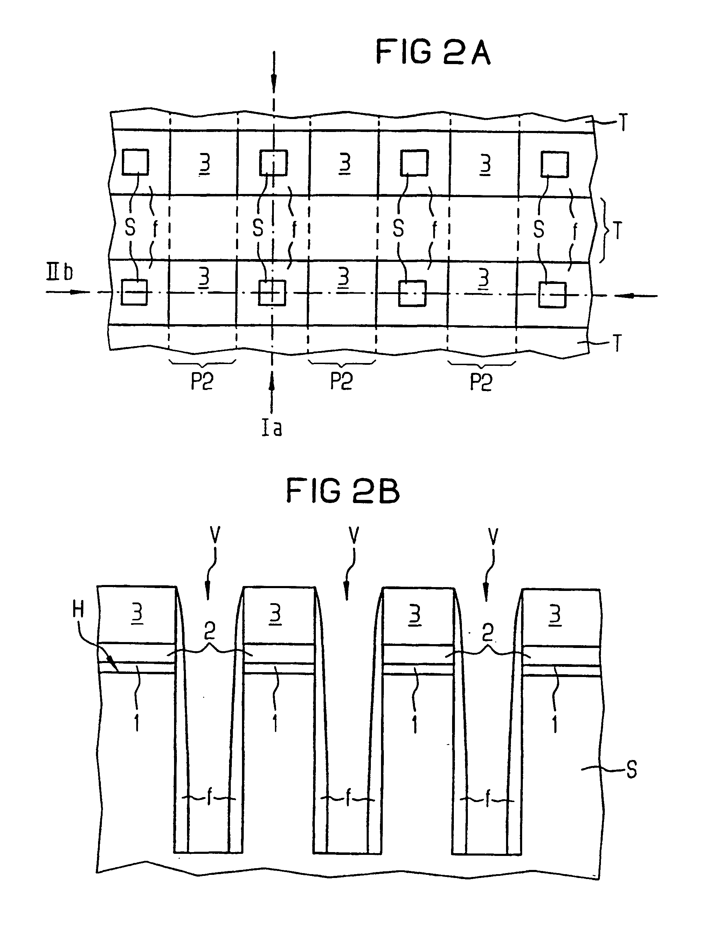

Mit Hilfe einer streifenförmigen zweiten Photolackmaske P2 (siehe Figur 2a), deren Streifen quer zu den Streifen der ersten Photolackmaske verlaufen, wird SiO₂ selektiv zu Siliziumnitrid mit zum Beispiel C₄F₆, CO geätzt, bis die zweite Schicht 2 teilweise freigelegt wird. Anschließend wird Siliziumnitrid geätzt, so daß die Hilfsstrukturen Q und freiliegende Teile der zweiten Schicht 2 entfernt werden. Durch Ätzen von Silizium selektiv zu SiO₂ wird aufgrund der endlichen Selektivität des Ätzprozesses zunächst die erste Schicht 1 teilweise durchtrennt und anschließend obere Bereiche von Vertiefungen V erzeugt. Dabei wirken die Trennstrukturen T und die dritte Schicht 3 als dicke Maske. Die oberen Bereiche der Vertiefungen V sind ca. 300 nm tief im Substrat S und weisen zur Hauptfläche H parallele Querschnitte auf, die quadratisch sind und deren Abmessungen ca. 100 nm betragen. Abstände zwischen zueinander benachbarte Vertiefungen V betragen ca. 100 nm voneinander (siehe Figuren 2a und 2b).

In den Vertiefungen V werden Hilfsspacer f erzeugt, indem SiO₂ in einer Dicke von ca. 30 nm abgeschieden und anisotrop rückgeätzt wird (siehe Figuren 2a und 2b). Freiliegende Teile der Böden der Vertiefungen sind im wesentlichen quadratisch und weisen eine Seitenlänge von ca. 40 nm auf.

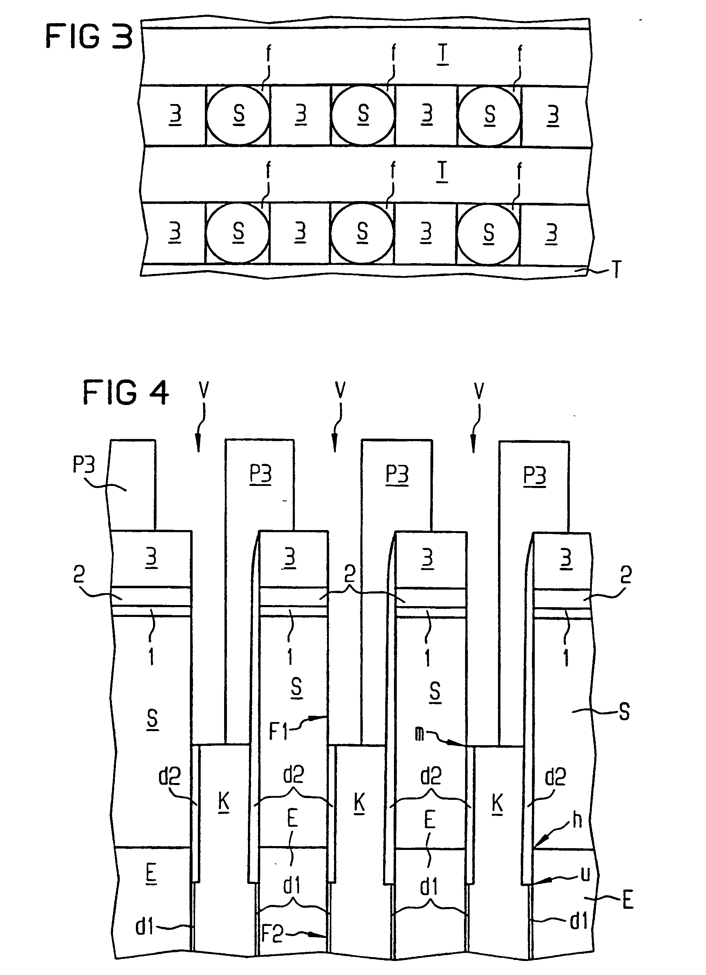

Zum Abrunden der Hilfsspacer f wird anschließend eine isotrope Rückätzung mit zum Beispiel CF₄ als Ätzmittel durchgeführt (siehe Figur 3). Freiliegende Teile der Böden der Vertiefungen V sind im wesentlichen kreisförmig und weisen einen Durchmesser von ca. 100 nm auf.

Anschließend wird Silizium selektiv zu SiO₂ mit zum Beispiel HBr anisotrop geätzt, so daß untere Bereiche der Vertiefungen V entstehen, die aufgrund der als Maske wirkenden Hilfsspacer f kreisförmige horizontale Querschnitte aufweisen. Die Vertiefungen V sind nun ca. 7 µm tief (siehe Figur 4). Beim Atzen wirken die Trennstrukturen T und die dritte Schicht 3 als dicke Maske.

Die oberen Bereiche der Vertiefungen V weisen jeweils vier seitliche ebene erste Flächen F1 auf. Die unteren Bereiche der Vertiefungen V weist eine gekrümmte zweite Fläche F2 auf. Ein horizontaler, d.h. parallel zur Hauptfläche H liegender Querschnitt des unteren Bereichs einer der Vertiefungen V weist einen gekrümmten Umfang auf. Ein Teil des Substrats S ist insbesondere unter Ecken der oberen Bereiche der Vertiefungen V angeordnet, da die Hilfsspacer f mindestens die Ekken bedecken und dort folglich nicht tiefer geätzt wird.

Zur Erzeugung einer Kondensatorelektrode E von Kondensatoren wird Arsenglas in einer Dicke von ca. 10 nm abgeschieden. Die mit dem Arsenglas versehenen Vertiefungen V werden bis zu einer Höhe h von ca. 1 µm unter der Hauptfläche H (vergleiche Fig. 4) mit Photolack gefüllt. Anschließend wird freiliegendes Arsenglas entfernt. Nach Entfernung des Photolacks wird ein Schutzoxid (nicht dargestellt) aufgewachsen. Das Schutzoxid verhindert, daß bei einem folgenden Temperschritt bei ca. 1000°C, bei dem Arsen aus dem Arsenglas in das Substrat S diffundiert, Arsen verdampft. Dadurch wird die Kondensatorelektrode E als ein mit Arsen dotierter Teil des Substrats S erzeugt, die Teile der unteren Bereiche der Vertiefungen V umgibt (siehe Figur 4). Das Schutzoxid und die Hilfsspacer f werden anschließend mit verdünnter Flußsäure entfernt.

Zur Erzeugung eines ersten Teils d1 eines Kondensatordielektrikums werden Flächen der Vertiefungen V mit Siliziumnitrid versehen, das anschließend teilweise aufoxidiert wird, so daß der erste Teil d1 des Kondensatordielektrikums als sogenannte NO-Schicht mit einer ca. 3 nm oxidäquivalenten Dicke erzeugt wird (siehe Figur 4).

Zur Erzeugung von Speicherknoten K der Kondensatoren wird in situ dotiertes Polysilizium in einer Dicke von ca. 100 nm abgeschieden und durch chemisch-mechanisches Polieren planarisiert, bis die zweite Schicht 2 freigelegt wird. Dabei wird die dritte Schicht 3 entfernt und die Trennstrukturen T etwas abgetragen. Anschließend wird das Polysilizium bis zu einer Tiefe von 1,1 µm unterhalb der Hauptfläche H durch anisotropes Ätzen rückgeätzt, so daß die Vertiefungen V bis zu einer unteren Höhe u mit Polysilizium gefüllt werden (siehe Figur 4). Freiliegende Teile des ersten Teils d1 des Kondensatordielektrikums werden mit zum Beispiel Flußsäure entfernt.

Zur Erzeugung eines spacerförmigen zweiten Teils d2 des Kondensatordielektrikums in den Vertiefungen V wird SiO₂ in einer Dicke von ca. 15 nm abgeschieden und anisotrop rückgeätzt (siehe Figur 4). Der zweite Teil d2 des Kondensatordielektrikums ist dicker als der erste Teil d1.

Durch Abscheiden von in situ dotiertem Polysilizium in einer Dicke von ca. 100 nm und anschließendem Rückätzen bis zu einer Tiefe von ca. 250 nm unterhalb der Hauptfläche H werden die Speicherknoten K vergrößert. Die Vertiefungen V sind bis zu einer mittleren Höhe m mit Polysilizium gefüllt (siehe Figur 4) .

Mit Hilfe einer mehrschichtigen dritten Fotolackmaske P3 (siehe Figur 4) werden Teile des zweiten Teils d2 des Kondensatordielektrikums entfernt. An ersten Flanken der Vertiefungen V reicht der zweite Teil d2 des Kondensatordielektrikums nur von der unteren Höhe u bis zur mittleren Höhe m.

Anschließend wird in situ dotiertes Polysilizium in einer Dicke von ca. 100 nm abgeschieden und durch chemisch-mechanisches Polieren planarisiert, bis die zweite Schicht 2 freigelegt wird.

Unter der ersten Schicht 1 werden durch Implantation mit n-dotierenden Ionen im Substrat S ca. 30 nm dicke obere Source/Drain-Gebiete S/D1 von vertikalen Transistoren erzeugt. Aufgrund der Trennstrukturen T und der Vertiefungen V weisen die oberen Source/Drain-Gebiete S/D1 quadratische horizontale

Querschnitte mit einer Seitenlänge von ca. 100 nm auf. Zueinander benachbarte obere Source/Drain-Gebiete S/D1 sind durch die Trennstrukturen T oder durch die Vertiefungen V voneinander getrennt.

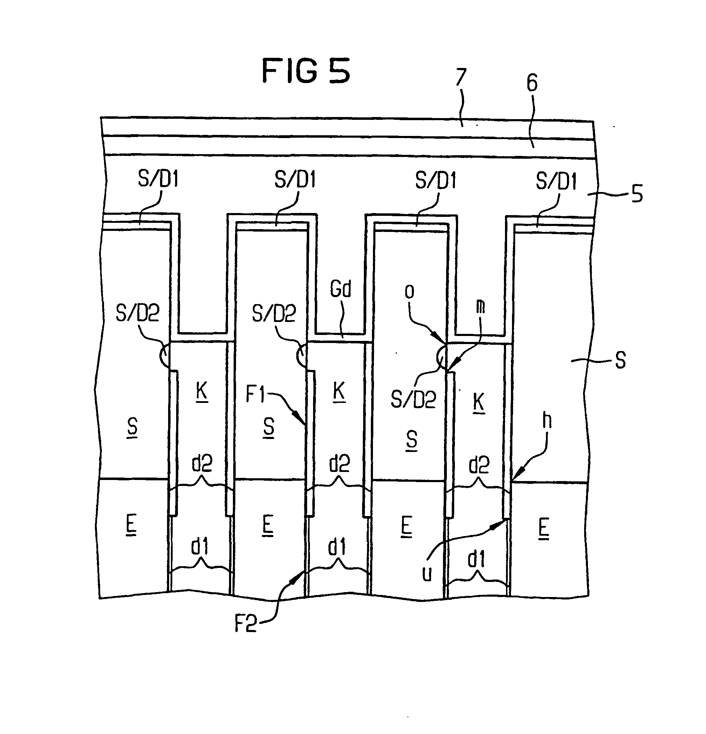

Das Polysilizium wird anschließend bis zu einer Tiefe von ca. 200 nm unterhalb der Hauptfläche H rückgeätzt, so daß die Speicherknoten K weiter verdickt werden. Die Vertiefungen V sind bis zu einer oberen Höhe h mit Polysilizium gefüllt (siehe Figur 5). Die Speicherknoten K grenzen bei den ersten Flanken der Vertiefungen V zwischen der mittleren Höhe m und der oberen Höhe o an das Substrat S an. Obere Teile der Speicherknoten K sind in den oberen Bereichen der Vertiefungen V angeordnet. Durch einen Temperschritt diffundiert Dotierstoff aus dem Speicherknoten K in das Substrat S, so daß untere Source-/Drain-Gebiete S/D2 der Transistoren erzeugt werden, die im Bereich zwischen der mittleren Höhe m und der oberen Höhe o an die ersten Flanken der Vertiefungen V angrenzen.

Anschließend wird die zweite Schicht 2 mit zum Beispiel weißer Phosphorsäure als Ätzmittel entfernt.

Durch thermische Oxidation wird ein Gatedielektrikum Gd an Flanken der oberen Bereiche der Vertiefungen V, auf der Hauptfläche H und auf den Speicherknoten K erzeugt (siehe Figur 5) .

Anschließend wird eine fünfte Schicht 5 aus in situ dotiertem Polysilizium in einer Dicke von ca. 60 nm abgeschieden, so daß die oberen Bereiche der Vertiefungen V gefüllt werden.
Darüber wird eine ca. 50 nm dicke sechste Schicht 6 aus Wolframsilizid und eine ca. 100 nm dicke siebte Schicht 7 aus Siliziumnitrid abgeschieden (siehe Figur 5).

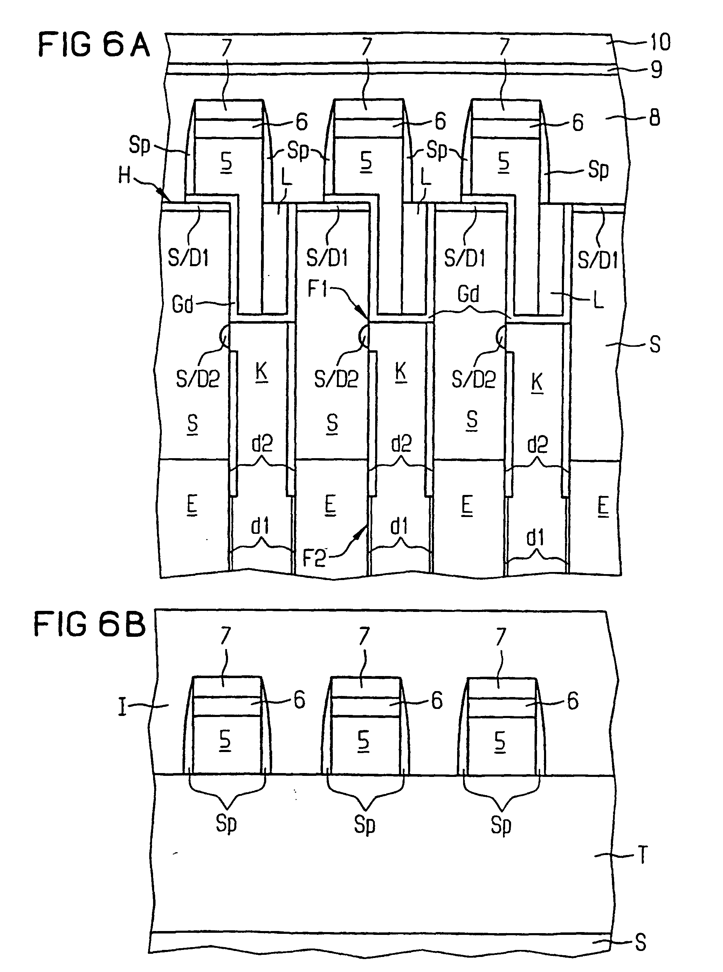

Mit Hilfe einer streifenförmigen vierten Photolackmaske (nicht dargestellt), deren Streifen quer zu den Trennstrukturen T verlaufen, werden die siebte Schicht 7, die sechste Schicht 6 und die fünfte Schicht 5 geätzt, bis das Gatedielektrikum Gd freigelegt wird. Jeweils ein Teil der fünften Schicht 5 und ein Teil der sechsten Schicht 6, die aneinander grenzen bilden eine Wortleitung, die von der isolierenden siebten Schicht 7 bedeckt wird (siehe Figur 6a). Die Wortleitungen sind ca. 100 nm breit und weisen einen Abstand von ca. 100 nm voneinander auf. Die Wortleitungen sind versetzt zu den Vertiefungen V angeordnet, so daß erste Teile der Wortleitungen einen streifenförmigen horizontalen Querschnitt aufweisen und über Teilen der vom Gatedielektrikum Gd bedeckten oberen Source/Drain-Gebiete S/D1 verlaufen. Zweite Teile der Wortleitungen sind in den oberen Bereichen der Vertiefungen V an deren ersten Flanken angeordnet. Die Wortleitungen haben eine metallische Leitfähigkeit.

Zur Erzeugung von isolierenden Strukturen L in den Vertiefungen V wird SiO₂ in einer Dicke von ca. 50 nm abgeschieden und rückgeätzt, bis das Gatedielektrikum Gd, das aufgrund seiner Dichte schlechter ätzbar ist, freigelegt wird (siehe Figur 6a).

Zum Abkapseln der Wortleitungen werden Spacer Sp erzeugt, indem Siliziumnitrid in einer Dicke von ca. 15 nm abgeschieden und anisotrop rückgeätzt wird (siehe Figur 6a).

Zur Erzeugung einer Isolation 1 wird SiO₂ in einer Dicke von ca. 50 nm abgeschieden und durch chemisch-mechanisches Polieren planarisiert, bis eine ebene Fläche entsteht (siehe Figur 6b).

Mit Hilfe einer streifenförmigen fünften Photolackmaske (nicht dargestellt), deren Streifen jeweils über einer der Trennstrukturen T angeordnet sind, wird SiO₂ geätzt, bis die oberen Source/Drain-Gebiete S/D1 freigelegt werden und zweite Gräben in der Isolation I entstehen, die in Bereichen zwischen den Wortleitungen besonders tief sind und Kontaktlöcher bilden (siehe Figur 6a). Dabei werden Teile des Gatedielektrikums Gd entfernt. Die isolierende siebte Schicht 7 und die Spacer Sp schützen dabei die Wortleitungen, so daß sich für die zweiten Gräben eine große Justiertoleranz ergibt.

Zur Erzeugung von Bitleitungen wird eine achte Schicht 8 aus in situ dotiertem Polysilizium in einer Dicke von ca. 50 nm abgeschieden, so daß die zweiten Gräben gefüllt werden. Anschließend wird das Polysilizium rückgeätzt, bis ca. 30nm Polysilizium über der siebten Schicht liegt. Darüber wird eine ca. 20 nm dicke neunte Schicht 9 aus Titannitrid und Titan und eine ca. 60 nm dicke zehnte Schicht 10 aus Wolfram abgeschieden und durch chemisch-mechanisches Polieren planarisiert, bis die Isolation I freigelegt wird, so daß selbstjustiert in den zweiten Gräben aus der achten Schicht 8, der neunten Schicht 9 und der zehnten Schicht 10 Bitleitungen erzeugt werden. Erste Teile der Bitleitungen bilden Streifen, die quer zu den Wortleitungen verlaufen, und zweite Teile der Bitleitungen füllen die Kontaktlöcher und sind zwischen zueinander benachbarten Wortleitungen angeordnet (siehe Figur 6a). Die Bitleitungen haben metallische Leitfähigkeit.

Im Ausführungsbeispiel wird eine DRAM-Zellenanordnung erzeugt. Eine Speicherzelle umfaßt einen der vertikalen Transistoren und einen der Kondensatoren, der zum Transistor in Reihe geschaltet ist. Das Gatedielektrikum des Transistors ist an einer der ebenen ersten Flächen F1 angeordnet. Der ersten Teil des Kondensatordielektrikums ist an der gekrümmten zweiten Fläche F2 angeordnet.

Teile der Wortleitungen, die an den ersten Flanken der oberen Bereiche der Vertiefungen V angeordnet sind, wirken als Gateelektroden der Transistoren. Die isolierenden Strukturen L an den zweiten Flanken der Vertiefungen V verhindern, daß die in der Vertiefung V angeordnete Wortleitung einen Transistor ansteuert, der an einer zur Vertiefung V benachbarten Vertiefung V angeordnet ist.

Kanalgebiete der Transistoren sind Teile des Substrats S, die zwischen den oberen Source/Drain-Gebieten S/D1 und den unteren Source/Drain-Gebieten S/D2 angeordnet sind. Die Kanalgebiete der Transistoren sind miteinander verbunden, so daß aufgrund der genügend hohen Dotierstoffkonzentration der an die Hauptfläche H angrenzenden Schicht des Substrats S Floating-Body-Effekte vermieden werden.

Es sind viele Variationen des Ausführungsbeispieles denkbar, die ebenfalls im Rahmen der Erfindung liegen. So können Abmessungen der Schichten, Vertiefungen und Strukturen an die jeweiligen Erfordernisse angepaßt werden. Dasselbe gilt für die Dotierstoffkonzentrationen und für die Wahl von Materialien. So können die Wortleitungen und die Bitleitungen auch andere leitende Materialien als die im Ausführungsbeispiel angeführten enthalten.

Das untere Source/Drain-Gebiet eines der Transistoren kann zweigeteilt sein, so daß ein erster Teil an die erste Flanke und ein zweiter Teil an die zweite Flanke der zugehörigen Vertiefung angrenzt. In diesem Fall wird beim Entfernen des zweiten Teils des Kondensatordielektrikums bis zur mittleren Höhe keine Maske verwendet, so daß der zweite Teil des Kondensatordielektrikums an den zweiten Flanken der Vertiefungen ebenfalls bis zur mittleren Höhe entfernt wird. Der Speicherknoten grenzt sowohl bei der ersten Flanke als auch bei der zweiten Flanke an das Substrat an.

Auf die isolierenden Strukturen kann verzichtet werden, wenn der Abstand der zweiten Flanke der Vertiefung zum unteren Source/Drain-Gebiet des Transistors der benachbarten Vertiefung groß genug ist.

Sind die isolierenden Strukturen vorgesehen, können die unteren Source/Drain-Gebiete statt durch Ausdiffusion von Dotierstoff durch Strukturierung einer dotierten Schicht des Substrats erzeugt werden.

Die isolierenden Strukturen können erzeugt werden, indem bei der Abkapselung der Wortleitungen das Siliziumnitrid in einer solchen Dicke abgeschieden wird, daß sich die Vertiefungen füllen. In diesem Fall bestehen die isolierenden Strukturen aus Siliziumnitrid.

## Patentansprüche

1. Verfahren zur Herstellung einer DRAM-Zellenanordnung,
- bei dem in einem Substrat (S) im wesentlichen parallel zueinander verlaufende erste Gräben erzeugt werden,
- bei dem die ersten Gräben mit Trennstrukturen (T) gefüllt werden,
- bei dem durch Ätzen das Substrat (S) selektiv zu den Trennstrukturen (T) geätzt wird, so dass Vertiefungen (V) erzeugt werden,
- bei dem Flächen von unteren Bereichen der Vertiefungen (V) mit einem Kondensatordielektrikum (d1, d2) versehen werden,
- bei dem in den unteren Bereichen der Vertiefungen (V) jeweils ein Speicherknoten (K) eines Speicherkondensators erzeugt wird,
- bei dem obere Source/Drain-Gebiete (S/D1) der Transistoren angrenzend an eine Hauptfläche (H) des Substrats (S) so erzeugt werden, dass sie jeweils zwischen zwei zueinander benachbarten Vertiefungen (V) und zwischen zwei zueinander benachbarten Trennstrukturen(T) angeordnet sind,
- bei dem mindestens erste Flanken der Vertiefungen(V) in oberen Bereichen der Vertiefungen(V) mit einem Gatedielektrikum (Gd) versehen werden,
- bei dem untere Source-/Drain-Gebiete (S/D2) der Transistoren im Substrat (S) so gebildet werden, dass sie mit den Speicherknoten (K) elektrisch verbunden sind, so dass jeweils einer der Transistoren und einer der Speicherkondensatoren in Reihe geschaltet sind und eine Speicherzelle bilden,
- bei dem durch Abscheiden und Strukturieren von leitendem Material Wortleitungen erzeugt werden, die quer zu den Trennstrukturen (T) und oberhalb der Hauptfläche (H) verlaufen, und daran angrenzend Gateelektroden von vertikalen Transistoren erzeugt werden, die jeweils in einer der Vertiefungen (V) angeordnet und von den Speicherknoten (K) elektrisch isoliert sind,
- bei dem über den Wortleitungen eine isolierende Schicht (7) erzeugt wird,
- bei dem durch Abscheiden und Rückätzen von Material isolierende Spacer (Sp) an den Wortleitungen erzeugt werden,
- bei dem mit Hilfe einer streifenförmigen Photolackmaske, deren Streifen im wesentlichen parallel zu den Trennstrukturen (T) verlaufen, selektiv zur isolierenden Schicht (7) und den Spacern (Sp) geätzt wird, bis die oberen Source/Drain-Gebiete (S/D1) freigelegt werden,
- bei dem Bitleitungen erzeugt werden, die die oberen Source/Drain-Gebiete (S/D1) kontaktieren,
**dadurch gekennzeichnet, dass**
- zunächst der obere Bereich der Vertiefungen (V) mittels einer streifenförmigen Photolackmaske (p2), deren Streife quer zu den ersten Gräben verlaufen, derart erzeugt wird, dass er einen im wesentlichen rechteckigen horizontalen Querschnitt aufweist,
- bei dem durch Abscheiden und anisotropes Rückätzen von Material Hilfsspacer (f) in den Vertiefungen (V) erzeugt werden,
- bei dem durch anisotropes Ätzen selektiv zu den Hilfsspacern (f) die unteren Bereiche der Vertiefungen (V) erzeugt werden.
- bei dem durch einen isotropen Ätzprozess die Hilfsspacer (f) abgerundet werden, so dass freiliegende Teile von Böden der Vertiefungen (V) einen Umfang mit einem ellipsen förmigen horizontalen Querschnitt aufweisen und der rechteckförmige horizontalen Querschnitt größer als der ellipsen förmige horizontale Querschnitt ist.

2. Verfahren nach Anspruch 1,
- bei dem eine Isolation (I) erzeugt wird, die die isoliernde Schicht (7) bedeckt,
- bei dem beim Ätzen selektiv zur isolierenden Schicht (7) und zu den Spacern (Sp) zweite Gräben in der Isolation (I) erzeugt werden,
- bei dem die Bitleitungen in den zweiten Gräben selbstjustiert erzeugt werden, indem mindestens ein leitendes Material abgeschieden und abgetragen wird, bis die Isolation (I) freigelegt wird.

3. Verfahren nach Anspruch 1 bis 2,
- bei dem nach Erzeugung der Vertiefungen (V) das Kondensatordielektrikum (d1, d2) aufgebracht wird,
- bei dem die Vertiefungen (V) bis zu einer mittleren Höhe (m) mit leitendem Material gefüllt werden,
- bei dem freiliegende Teile des Kondensatordielektrikums (d1, d2) entfernt werden,
- bei dem die Vertiefungen (V) durch leitendes Material bis zu einer oberen Höhe (o), die über der mittleren Höhe (m) liegt, weiter aufgefüllt werden, so dass aus dem leitenden Material Speicherknoten (K) erzeugt werden, die zumindest teilweise in den unteren Bereichen der Vertiefungen (V) angeordnet sind,
- bei dem die unteren Source-/Drain-Gebiete (S/D2) so erzeugt werden, dass sie zwischen der mittleren Höhe (m) und der oberen Höhe (o) an die Speicherknoten (K) angrenzen.

4. Verfahren nach Anspruch 3,
- bei dem nach Erzeugung der Vertiefungen (V) ein erster Teil (d1) des Kondensatordielektrikums aufgebracht wird,
- bei dem die Vertiefungen (V) durch leitendes Material bis zu einer unteren Höhe (u), die unterhalb der mittleren Höhe (m) liegt, gefüllt werden,
- bei dem freiliegende Teile des ersten Teils (d1) des Kondensatordielektrikums entfernt werden,
- bei dem ein zweiter Teil (d2) des Kondensatordielektrikums aufgebracht wird, der dicker als der erste Teil (d1) des Kondensatordielektrikums ist,
- bei dem die Vertiefungen (V) bis zur mittleren Höhe (m) mit leitendem Material gefüllt werden.

5. Verfahren anch Anspruch 3 oder 4,
- bei dem nach Füllen der Vertiefungen (V) bis zur mittleren Höhe (m) die freiliegenden Teile des Kondensatordielektrikums (d1, d2) so entfernt werden, dass selektiv zu einer Photolackmaske (P3), die die zweiten Flanken der Vertiefungen (V) bedeckt, geätzt wird.

6. Verfahren nach Anspruch 5,
- bei dem die Wortleitungen versetzt zu den Vertiefungen (V) erzeugt werden, so dass die Gateelektroden an die mit dem Gatedielektrikum (Gd) versehenen Teile der ersten Flanken der Vertiefungen (V) angrenzen, aber nicht an zweite, den ersten Flanken gegenüberliegende Flanken der Vertiefungen (V),
- bei dem isolierendes Material abgeschieden und rückgeätzt wird, so dass in den Vertiefungen (V) isolierende Strukturen (L) erzeugt werden, die an die zweiten Flanken und an die Gateelektrode angrenzen.

7. Verfahren nach einem der Ansprüche 1 bis 6,
- bei dem zur Erzeugung der unteren Source-/Drain-Gebiete (S/D2) ein Temperschritt durchgeführt wird, so dass Dotierstoff aus dem Speicherknoten (K) in das Substrat (S) diffundiert.

8. Verfahren nach einem der Ansprüche 1 bis 7,
- bei dem nach Erzeugung der Vertiefungen (V) Dotierstoff in das Substrat (S) diffundiert wird, so dass im Substrat (S) Kondensatorelektroden (E) der Speicherkondensatoren erzeugt werden, die ineinander übergehen und Teile der unteren Bereiche der Vertiefungen (V) umgeben.

9. Verfahren nach einem der Ansprüche 1 bis 8,
- bei dem auf der Hauptfläche (H) eine untere Schicht (3) aus einem ersten Material aufgebracht wird,
- bei dem auf der unteren Schicht (3) eine obere Schicht (4) aus einem zweiten Material aufgebracht wird,
- bei dem die Trennstrukturen (T) so erzeugt werden, dass sie aus dem ersten Material bestehen und dass eine obere Fläche der Trennstrukturen (T) über der Hauptfläche (H) und unter einer oberen Fläche der unteren Schicht (3) liegt,
- bei dem über den Trennstrukturen (T) Hilfsstrukturen (Q) auf dem zweiten Material erzeugt werden,
- bei dem das zweite Material geätzt wird, bis die untere Schicht (3) freigelegt wird, so dass ein Teil der Hilfsstrukturen(Q) erhalten bleibt,
- bei dem mit der streifenförmigen Photolackmaske (P2) für die Erzeugung der Vertiefungen (V) zunächst das erste Material selektiv zum zweiten Material geätzt wird, so dass die obere Fläche der Trennstrukturen (T) unverändert oberhalb der Hauptfläche (H) liegt,
- bei dem die Vertiefungen (V) erzeugt werden, wobei trotz endlicher Selektivität des verwendeten Ätzprozesses die obere Fläche der Trennstrukturen (T) nicht unter die Hauptfläche (H) sinkt.

## Claims

1. Method for fabricating a DRAM cell arrangement
- in which first trenches running essentially parallel to one another are produced in a substrate (S),
- in which the first trenches are filled with isolating structures (T),
- in which, by etching, the substrate (S) is etched selectively with respect to the isolating structures (T), with the result that depressions (V) are produced,
- in which areas of lower regions of the depressions (V) are provided with a capacitor dielectric (d1, d2),
- in which a storage node (K) of a storage capacitor is in each case produced in the lower regions of the depressions (V),
- in which upper source/drain regions (S/D1) of the transistors are produced in a manner adjoining a main area (H) of the substrate (S) in such a way that they are in each case arranged between two mutually adjacent depressions (V) and between two mutually adjacent isolating structures (T),
- in which at least first side walls of the depressions (V) are provided with a gate dielectric (Gd) in upper regions of the depressions (V),
- in which lower source/drain regions (S/D2) of the transistors are formed in the substrate (S) in such a way that they are electrically connected to the storage nodes (K), with the result that in each case one of the transistors and one of the storage capacitors are connected in series and form a memory cell,
- in which, by depositing and patterning conductive material, word lines are produced, which run transversely with respect to the isolating structures (T) and above the known area (H), and, adjoining them, gate electrodes of vertical transistors are produced, which are each arranged in one of the depressions (V) and are electrically insulated from the storage nodes (K),
- in which an insulating layer (7) is produced over the word lines,
- in which insulating spacers (Sp) are produced on the word lines by depositing material and etching it back,
- in which, with the aid of a strip-shaped photoresist mask whose strips run essentially parallel to the isolating structures (T), etching is effected selectively with respect to the insulting layer (7) and the spacers (Sp) until the upper source/drain regions (S/D1) are uncovered,
- in which bit lines are produced which make contact with the upper source/drain regions (S/S1).
**characterized in that**
- firstly the upper region of the depressions (V) is produced using a strip-shaped photoresist mask (P2), whose strips run transversely with respect to the first trenches, in such a way that it has an essentially rectangular horizontal cross section,
- in which auxiliary spacers (f) are produced in the depressions (V) by depositing material and anisotropically etching it back,
- in which the lower regions of the depressions (V) are produced by anisotropic etching selectively with respect to the auxiliary spacers (f),
- in which the auxiliary spacers (f) are rounded by an isotropic etching process, with the result that uncovered parts of bottoms of the depressions (V) have a circumference with an elliptical horizontal cross section and the rectangular horizontal cross section is greater than the elliptical horizontal cross section.

2. Method according to Claim 1,
- in which an insulation (I) is produced which covers the insulating layer (7),
- in which, during the process of etching selectively with respect to the insulating layer (7) and with respect to the spacers (Sp), second trenches are produced in the insulation (I),
- in which the bit lines are produced in a self-aligned manner in the second trenches by at least one conductive material being deposited and removed until the insulation (I) is uncovered.

3. Method according to Claim 1 or 2,
- in which, after the production of the depressions (V), the capacitor dielectric (d1, d2) is applied,
- in which the depressions (V) are filled with conductive material up to a middle height (m),
- in which uncovered plots of the capacitor dielectric (d1, d2) are removed,
- in which the depressions (V) are filled further by conductive material up to an upper height (o), which lies above the middle height (m), with the result that storage nodes (K) which are at least partially arranged in the lower regions of the depression (V) are produced from the conductive material,
- in which the lower source/drain regions (S/D2) are produced in such a way that they adjoin the storage nodes (K) between the middle height (m) and the upper height (o).

4. Method according to Claim 3,
- in which, after the production of the depressions (V), a first part (d1) of the capacitor dielectric is applied,
- in which the depressions (V) are filled by conductive material up to a lower height (u), which lies below the middle height (m),
- in which uncovered parts of the first part (d1) of the capacitor dielectric are removed,
- in which a second part (d2) of the capacitor dielectric is applied, which is thicker than the first part (d1) of the capacitor dielectric,
- in which the depressions (V) are filled with conductive material up to the middle height (m).

5. Method according to Claim 3 or 4,
- in which, after the filling of the depressions (V) up to the middle height (m), the uncovered parts of the capacitor dielectric (d1, d2) are removed in such a way that etching is effected selectively with respect to a photoresist mask (P3) which covers the second side walls of the depressions (V).

6. Method according to Claim 5,
- in which the word lines are produced offset with respect to the depressions (V), with the result that the gate electrodes adjoin those parts of the first side walls of the depressions (V) which are provided with the gate dielectric (Gd), but not second side walls - opposite to the first side walls - of the depressions (V),
- in which insulating material is deposited and etched back, with the result that insulating structures (L) which adjoin the second side walls and the gate electrode are produced in the depressions (V).

7. Method according to one of Claims 1 to 6,
- in which, in order to produce the lower source/drain regions (S/D2), a heat-treatment step is carried out, with the result that dopant diffusers from the storage node (K) into the substrate (S).

8. Method according to one of Claims 1 to 7,
- in which, after the production of the depressions (V), dopant is diffused into the substrate (S), thereby producing the substrate (S) capacitor electrodes (E) of the storage capacitors which merge with one another and surround parts of the lower regions of the depressions (V).

9. Method according to one of Claims 1 to 8,
- in which an upper layer (4) made of a second material is applied on the lower layer (3),
- in which the isolating structures (T) are produced in such a way that they are composed of the first material and that an upper area of the isolating structures (T) lies above the main area (H) and below an upper area of the lower layer (3),
- in which auxiliary structures (T) made of the second material are produced above the isolating structures (T),
- in which the second material is etched until the lower layer (3) is uncovered, with the result that a part of the auxiliary structures (T) is preserved,
- in which, using the strip-shaped photoresist mask (P2) for the production of the depressions (V), firstly the first material is etched selectively with respect to the second material, with the result that the upper area of the isolating structures (T) lies above the main area (H) in an unchanged manner,
- in which the depressions (V) are produced, the upper area of the isolating structures (T) not sinking below the main area (H), despite a finite selectivity of the etching process used.

## Revendications

1. Procédé de fabrication d'un groupement de cellules DRAM, dans lequel
- dans lequel des premières tranchées s'étendant substantiellement parallèlement les unes aux autres sont produites dans un substrat (S),
- dans lequel les premières tranchées sont remplies avec des structures séparatrices (T),
- dans lequel le substrat (S) est sélectivement gravé par rapport aux structures séparatrices (T) de manière à ce que des creux (V)soient produits,
- dans lequel des surfaces de zones inférieures des creux (V) sont munies d'un diélectrique de condensateur (d1, d2),
- dans lequel dans les zones inférieures des creux (V) un noeud de stockage (K) d'un condensateur de stockage est respectivement produit,
- dans lequel des zones source / drain supérieures (S / D1) des transistors adjacentes à une surface principale (H) du substrat (S) sont produites de telle sorte qu'elles sont agencées respectivement entre deux creux (V) voisins l'un de l'autre et entre deux structures séparatrices (T) voisines l'une de l'autre,
- dans lequel au moins des premiers flancs des creux (V) dans des zones supérieures des creux (V) sont munis d'un diélectrique de grille (Gd),
- dans lequel des zones source / drain inférieures (S / D2) des transistors dans le substrat (S) sont formées de telle sorte qu'elles sont reliées électriquement aux noeuds de stockage (K) de telle sorte que, respectivement, l'un des transistors et l'un des condensateurs de stockage sont branchés en série et forment une cellule de mémoire,
- dans lequel en déposant et structurant du matériau conducteur, des lignes de mots sont produites qui s'étendent transversalement aux structures séparatrices (T) et au-dessus de la surface principale (H) et ,adjacentes à celles-ci, des électrodes de grille de transistors verticaux sont produites qui sont respectivement agencées dans l'un des creux (V) et isolées électriquement des noeuds de mémoire (K),
- dans lequel une couche isolante (7) est produite au-dessus des lignes de mots,
- dans lequel en déposant un matériau et en le gravant en retrait, des espaceurs isolants (Sp) sont produits sur les lignes de mots,
- dans lequel à l'aide d'un masque de photorésist en forme de bandes dont les bandes s'étendent substantiellement parallèlement aux structures séparatrices (T), une gravure sélective par rapport à la couche isolante (7) et aux espaceurs (Sp) est effectuée jusqu'à ce que les zones source / drain supérieures (S / D1) soient dégagées,
- dans lequel des lignes de bits sont produites qui mettent en contact les zones source / drain supérieures (S / D1),
**caractérisé en ce que**
- d'abord la zone supérieure des creux (V) est produite au moyen d'un masque de photorésist en forme de bandes (P2) dont les bandes s'étendent transversalement aux premières tranchées, de telle sorte qu'elle a une section transversale horizontale substantiellement rectangulaire,
- dans lequel en déposant du matériau et en le gravant en retrait de façon anisotrope, des espaceurs auxiliaires (f) sont produits dans les creux (V),
- dans lequel en effectuant une gravure anisotrope sélectivement par rapport aux espaceurs auxiliaires (f), les zones inférieures des creux (V) sont produites,
- dans lequel en réalisant un processus de gravure isotrope, les espaceurs auxiliaires (f) sont arrondis de telle sorte que des parties dégagées de fonds des creux (V) ont un périmètre avec une section transversale horizontale en forme d'ellipse et que la section transversale horizontale rectangulaire est plus grande que la section transversale horizontale en forme d'ellipse.

2. Procédé selon la revendication 1,
- dans lequel une isolation (I), qui couvre la couche isolante (7) est produite,
- dans lequel lors de la gravure sélective par rapport à la couche isolante (7) et aux espaceurs (Sp), des deuxièmes tranchées dans l'isolation (I)sont produites,
- dans lequel les lignes de bits sont produites dans les deuxièmes tranchées selon un alignement automatique en déposant au moins un matériau conducteur et en l'enlevant jusqu'à ce que l'isolation (I) soit dégagée.

3. Procédé selon la revendication 1 à 2,
- dans lequel après la production des creux (V), le diélectrique de condensateur (d1, d2) est appliqué,
- dans lequel les creux (V) sont remplis jusqu'à une hauteur moyenne (m) avec du matériau conducteur,
- dans lequel des parties dégagées du diélectrique de condensateur (d1, d2) sont enlevées,
- dans lequel les creux (V) sont remplis en plus avec du matériau conducteur jusqu'à une hauteur supérieure (o) qui est au-dessus de la hauteur moyenne (m), de manière à ce que à partir du matériau conducteur des noeuds de stockage (K) soient produits qui sont agencés au moins partiellement dans les zones inférieures des creux (V),
- dans lequel les zones source / drain inférieures (S / D2) sont produites de telle sorte qu'elles sont adjacentes aux noeuds de stockage (K) entre la hauteur moyenne (m) et la hauteur supérieure (o).

4. Procédé selon la revendication 3,
- dans lequel après la production des creux (V), une première partie (d1) du diélectrique de condensateur est appliquée,
- dans lequel les creux (V) sont remplis avec un matériau conducteur jusqu'à une hauteur inférieure (u) qui se trouve au-dessous de la hauteur moyenne (m),
- dans lequel des parties dégagées de la première partie (d1) du diélectrique de condensateur sont enlevées,
- dans lequel une deuxième partie (d2) du diélectrique de condensateur, qui est plus épaisse que la première partie (d1) du diélectrique de condensateur est appliquée,
- dans lequel les creux (V) sont remplis jusqu'à la hauteur moyenne (m) avec un matériau conducteur.

5. Procédé selon la revendication 3 ou 4, dans lequel après remplissage des creux (V) jusqu'à la hauteur moyenne (m), les parties dégagées du diélectrique de condensateur (d1, d2) sont enlevées en effectuant une gravure sélective par rapport à un masque de photorésist (P3) qui couvre les deuxièmes flancs des creux (V).

6. Procédé selon la revendication 5,
- dans lequel les lignes de mots décalées par rapport aux creux (V) sont produites de telle sorte que les électrodes de grille sont adjacentes aux parties, munies du diélectrique de grille (Gd), des premiers flancs des creux (V), mais pas à des deuxièmes flancs, en face des premiers flancs des creux (V),
- dans lequel un matériau isolant est déposé et gravé en retrait de manière à ce que dans les creux (V) des structures isolantes (L) soient produites, qui sont adjacentes aux deuxièmes flancs et à l'électrode de grille.

7. Procédé selon l'une des revendications 1 à 6, dans lequel pour produire les zones source / drain inférieures (S / D2), une étape de trempe est effectuée, de telle sorte qu'un agent de dopage est diffusé du noeud de stockage (K) dans le substrat (S).

8. Procédé selon l'une des revendications 1 à 7, dans lequel après la production des creux (V), un agent de dopage est diffusé dans le substrat (S), de manière à ce que dans le substrat (S) des électrodes (E) des condensateurs de stockage soient produites, qui se mêlent les unes aux autres et qui entourent des parties des zones inférieures des creux (V).

9. Procédé selon l'une des revendications 1 à 8,
- dans lequel sur la surface principale (H), une couche inférieure (3) en un premier matériau est appliquée,
- dans lequel sur la couche inférieure (3), une couche supérieure (4) en un deuxième matériau est appliquée,
- dans lequel les structures séparatrices (T)sont produites de telle sorte qu'elles sont constituées du premier matériau et qu'une surface supérieure des structures séparatrices (T) se trouve au-dessus de la surface principale (H) et au-dessous d'une surface supérieure de la couche inférieure (3),
- dans lequel au-dessus des structures séparatrices (T), des structures auxiliaires (Q)sont produites sur le deuxième matériau,
- dans lequel le deuxième matériau est gravé jusqu'à ce que la couche inférieure (3) soit dégagée, de telle sorte qu'il reste une partie des structures auxiliaires (Q),
- dans lequel avec le masque de photorésist en forme de bandes (P2), pour la production des creux (V), d'abord le premier matériau est gravé sélectivement par rapport au deuxième matériau de telle sorte que la surface supérieure des structures séparatrices (T) reste inchangée au-dessus de la surface principale (H),
- dans lequel les creux (V)sont produits, la surface supérieure des structures séparatrices (T) ne descendant pas au-dessous de la surface principale (H) malgré une sélectivité finie du processus de gravure utilisé.
